# EUROPEAN PATENT SPECIFICATION

(11) **EP 2 529 162 B1**
(45) Date of publication and mention of the grant of the patent: **26.03.2014**
(21) Application number: 11709471.4
(22) Date of filing: 31.01.2011
(51) Int. Cl.: F24J 2/46, B08B 6/00, H01L 31/0216

(54) **INTELLIGENT&SELF-CLEANING SOLAR PANELS**
INTELLIGENTE UND SELBSTREINIGENDE SOLARTAFELN
PANNEAUX SOLAIRES INTELLIGENTS ET AUTONETTOYANTS

(30) Priority: 29.01.2010 EP 10152092
(43) Date of publication of application: 05.12.2012
(73) Proprietor: Volotek SA, 1242 Satigny (CH)
(72) Inventor: MCKARRIS, George, CH-1217 Meyrin (CH)
(74) Representative: Grosfillier, Philippe
(86) International application number: PCT/IB2011/050422
(87) International publication number: WO 2011/092670

(56) References cited:
- EP-A1- 2 045 025
- US-A- 4 233 957
- US-A1- 2004 055 632

## Description

### Field of the invention and background

The present invention concerns the field of solar panels, and more specifically the field of intelligent and self-cleaning panels.

One of the major problems that has been identified with the use of solar panels (in particular the ones used in deserts and places where the sun illumination is particularly effective, is the frequent dust and sand cleaning off solar panels and glass façades which is needed.

Indeed, a regular cleaning of the solar panels has to be made in order to keep the efficiency at the highest percentage possible.

Efficiency of a solar panel can decrease by as much as 30% due to dirt and dust or even much more due to accumulated snow on the panel.

Solar panel manufacturers advise a minimum of one cleaning a month. In some situation it is not easy to climb to a roof in order to clean the panel.

Traditional cleaning causes scratches to surfaces, which reduces the efficiency of the panel. In most cases cleaning requires solvents, water, personnel time, equipment and machinery.

In addition, such solar panels are usually spread out on large areas to build large surfaces and the cleaning of such large areas is time consuming.

Prior art publication include:
- ) US 6,076,216 which disclose a method and apparatus for cleaning surfaces of dust by the use of an alternating electrical field with a low power consumption. The amplitude of the electrical field is between 1,000 and 30,000 V/cm and its frequency is from 10 to 1000 Hz.
- ) US 2002/0134399 discloses a method for collection of lunar dust particles includes the steps of providing a magnetic field source for attracting lunar dust particles, providing magnetic proximity between the lunar dust particles and the magnetic field source, and collecting lunar dust particles by the magnetic field source. An apparatus for the collection of lunar dust particles includes a magnetic field source, a structure for providing magnetic proximity between lunar dust particles and the magnetic field source, and a structure for collecting lunar dust particles by the magnetic field source. The apparatus can be utilized with a lunar living facility, such as a spaceship or lunar base. A self-cleaning solar cell includes at least one solar panel and a movable structure having a magnetic field source adapted for translation over the solar panel to collect accumulated particles.
- ) US 2007/0017567 discloses systems and materials to improve photovoltaic cell efficiency by implementing a self-cleaning function on photovoltaic cells and on albedo surfaces associated with photovoltaic cell assemblies.
- ) US 2007/0256732 discloses a photovoltaic module including at least one photovoltaic cell and a transparent layer. The transparent layer is positioned above the photovoltaic cell, wherein the transparent layer has a plurality of protruding parts arranged on at least one surface of the transparent layer, which faces the outside, inside or both of the photovoltaic module.
- ) US-A-2004055632 and EP-A-2045025 both disclose a panel comprising a self-cleaning device for cleaning the surface of the panel.

### Summary of the invention

An aim of the present invention is to propose improved solar panels over the known ones.

More specifically, an aim of the present invention is to proposed solar panels that are easy to clean in an effective way so that they keep their properties and efficiency over time.

Accordingly, the Applicant has developed an intelligent self-cleaning multilayer layer coating to address the cleaning of surfaces such as solar panels, glass windows or any similar surfaces that require cleaning.

The surface of a panel is equipped with various detectors such as luminosity, temperature, humidity and others for automatic operation or can be operated manually.

In the case of a transparent surface the light transmission efficiency is monitored regularly and compared with the initial factory calibration.

The intelligent electronics decides to activate the self-cleaning system in relation with the decrease in efficiency taking into consideration the time zone, luminosity, temperature and weather conditions of the region.

The electronics will activate four independent DC powered pulsed electrostatic fields when detecting dirt or sand on the panel or use the same elements on the surface to melt down the snow.

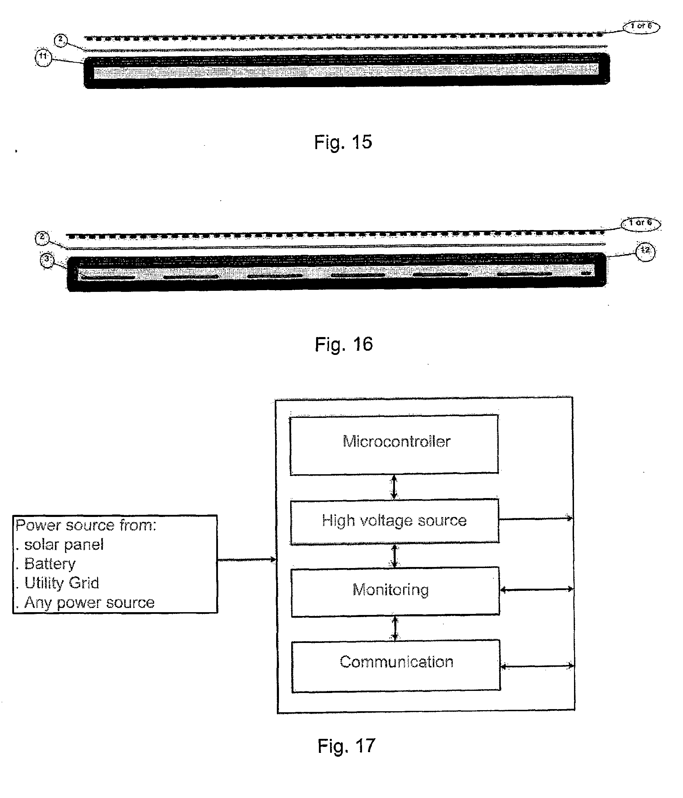

The electronic means (see figure 17) comprise typically the power input and regulation of the board, a microcontroller, monitoring electronics, electrostatic field power electronics and communication electronics.

This innovative technology uses a small percentage of the power produced by the solar panel and for a very short period of time.

In the case of other surfaces the electronic circuit has to be powered by other external sources.

### Detailed description of the invention

The present invention will be better understood from a detailed description and from the appended drawings which show:
Figure 1 illustrates the principle of the invention;
Figures 2 to 8 illustrate different embodiments of conductive coatings;
Figures 9 to 11 illustrate different embodiments of photovoltaic and thermal solar panels;
Figures 12 and 13 illustrate different embodiments of mirrors and reflectors for concentrated solar;
Figures 14 and 15 illustrate embodiments of facades, windows and windshields;
Figure 16 illustrates an embodiment of a vacuum based photovoltaic solar panel;
Figure 17 illustrates the main electronic board;
Figure 18 illustrates the ultrasonic cleaning system.

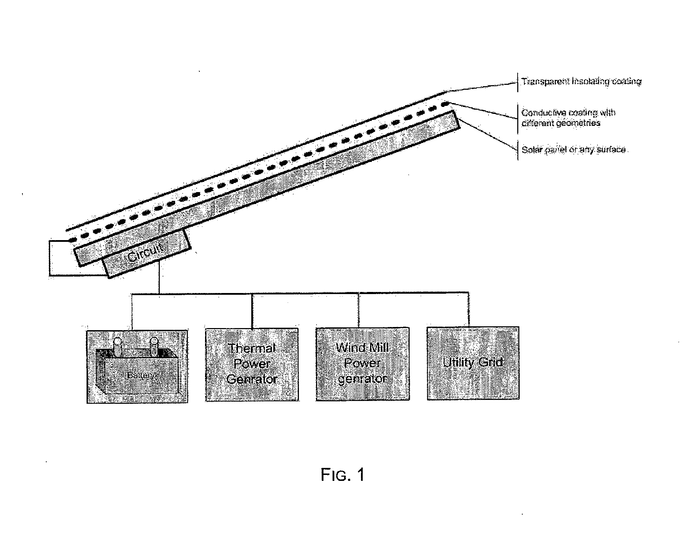

The present invention relates to a method and apparatus for levitating and conveying sand, dust or melting snow deposits off the surface of objects, in particular solar panels, mirrors, glass objects and the like. The principle of a panel according to the present invention is illustrated in figure 1, which comprises a panel or any surface on which a conductive coating with different geometries is applied, and then on top a transparent isolating coating is preferably added.

Accordingly, such apparatus employs various geometries of conductive traces (either transparent or opaque) embedded inside a thin layer on the surface of the object.

This invention employs multiple sensors and detectors used to monitor the surrounding, the environment, temperature, humidity and the performance of the object and activate either the cleaning or the snow melting process.

The detection system, the embedded traces on the surface and the power output of the object (in case of a solar panel) are all connected to an intelligent electronic board or circuit that takes decisions when to start any of the processes of cleaning or melting.

Many objects can be connected together, communicate with each other and are connected to a central station for remote monitoring and activation.

Four independent pulsed electrostatic fields, generated from a DC power supply (all other known devices use AC power supplies which require much more electronics and power), use the geometries of traces on the surface of the objects to repel dirt, dust and sand without scratching or damaging the surface of the object. The fields are interlaced with variable phase shift to ensure fast execution time.

Additional ultrasonic waves generated by piezoelectric devices placed on the surface can be used to provide additional cleaning means of dried humid sand, dust and the like.

The electronics go to standby or sleep mode when not being used.

Traces and electronics are also used for detecting and melting snow deposit off the surface of the object.

This invention saves the use of moving mechanical parts, water, detergent or any other cleaning method.

The power required for the traces on the surface and the electronics is very small. It can be drawn from various sources such as:
In the case of a Photovoltaic solar panel less than 10% of its power is required for less than one minute at least once a day. Otherwise power can be drawn from a battery, utility grid or
any other external sources as illustrated in figure 1.

In the case of vacuum or thermal solar panels, power can be drawn from their own generated power or any other external sources.

The applications of the present invention are numerous:
- ) Photovoltaic solar panels
- ) Thermal solar panels
- ) Vacuum solar panels
- ) Mirrors
- ) Glass
- ) Windshields
- ) Optical surfaces
- ) Facades etc.

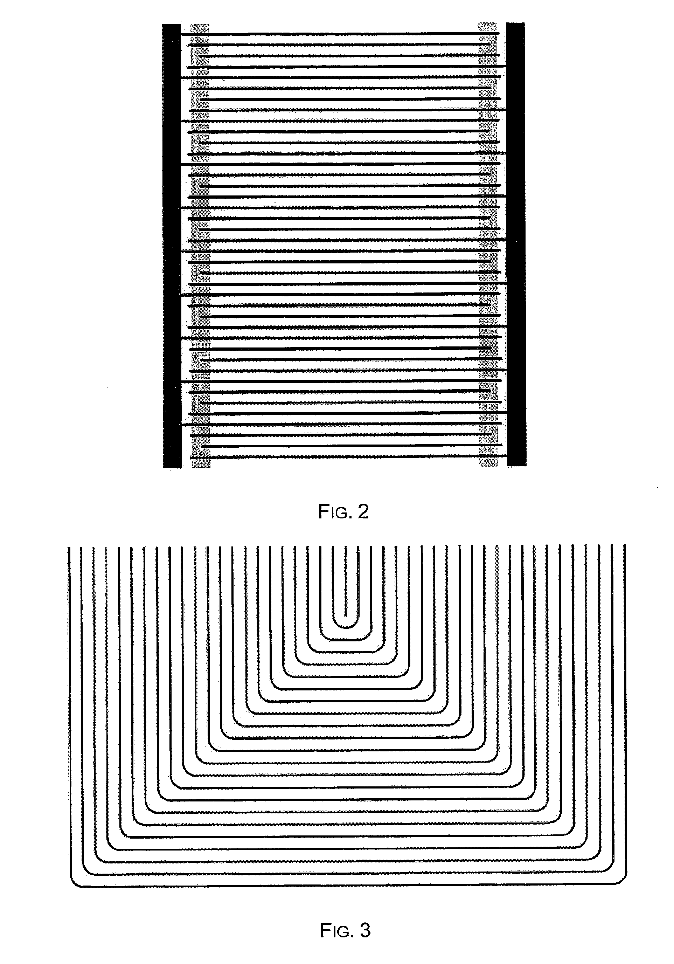

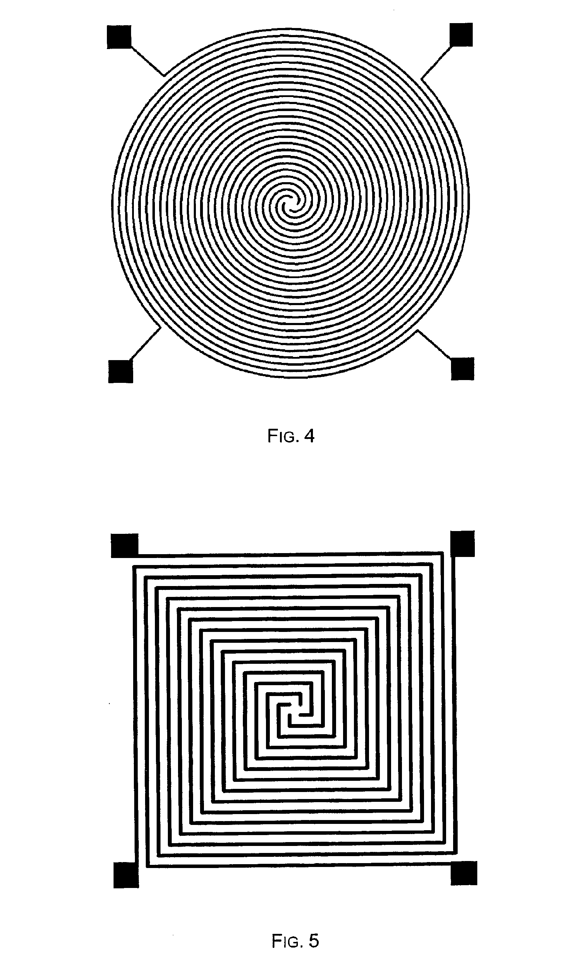

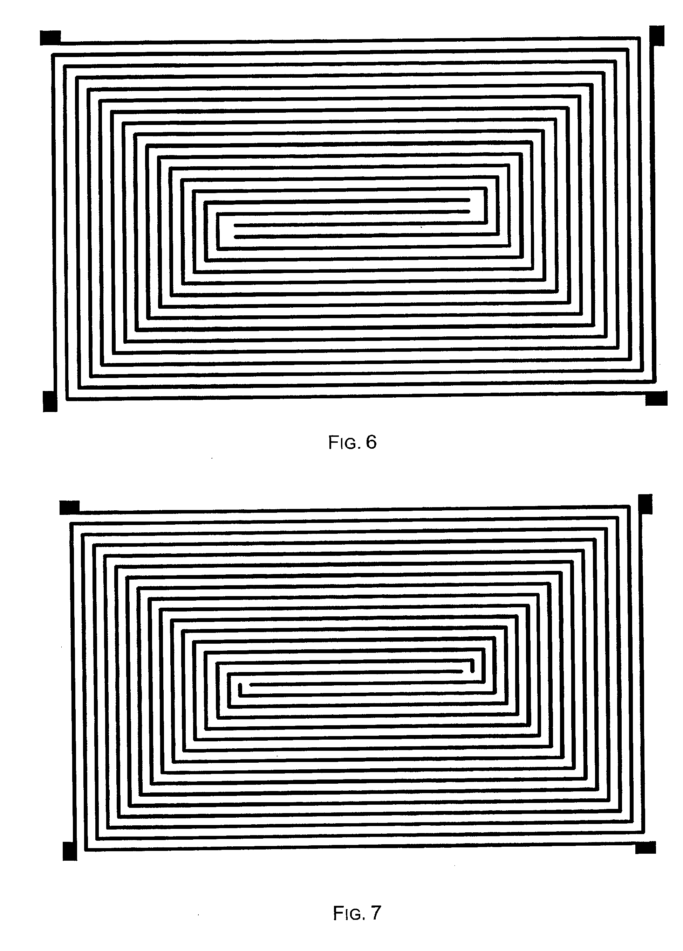

Figures 2 to 8 illustrate different shapes of conductive traces according to the present invention. As can readily be understood from these figures, the shapes can be different and have a suitable effect.

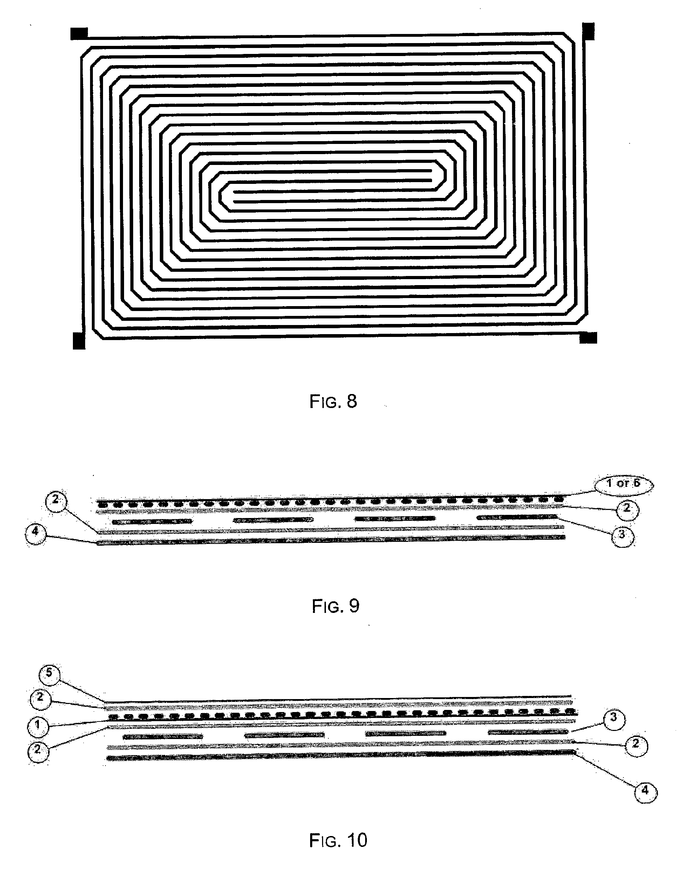

Figures 9 to 15 illustrate different embodiments as concrete applications of the present invention and the various geometries shown in the figures below and other similar and related geometries to cover different shapes of panels and surfaces.

For example, figures 9, 10 and 11 illustrate two embodiments of photovoltaic and thermal solar panels. In figure 9, there is a glass 1 or a polymer 6 with patterned, conductive layer deposited on either surface, with a highly transparent non-conductive resin 2, photovoltaic or thin film solar cells 3 and a back sheet made out of compound material 4.

In figure 10, there is in addition a further highly transparent non-conductive resin 2 layer and a thin highly transparent sheet 5 made out of polymers such as Teflon® or another equivalent material.

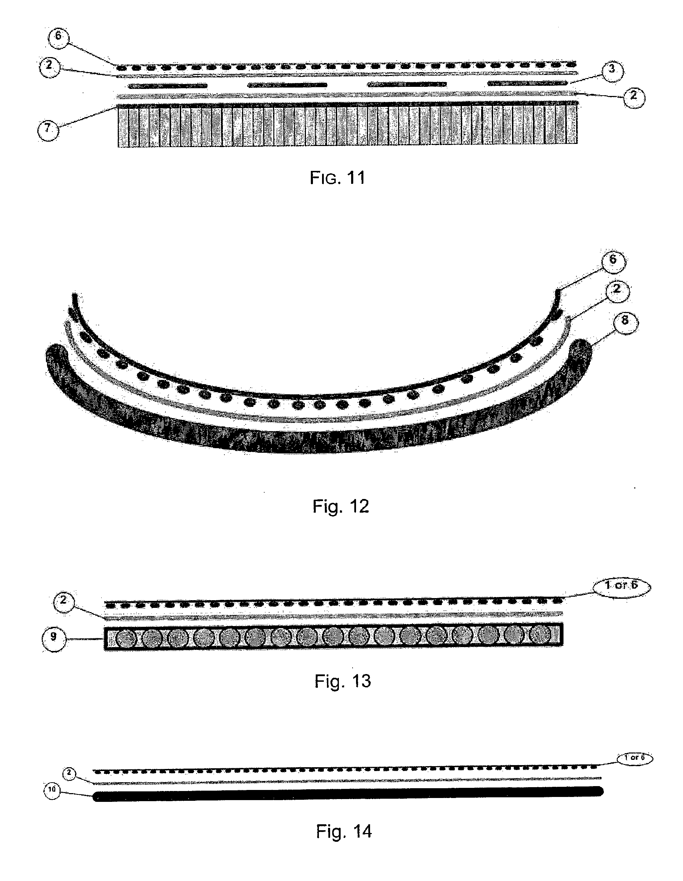

In figure 11, there is in addition a honeycomb backing 7 made out of metal for heat dissipation or out of other material for high rigidity and lightweight backing.

Figures 12 and 13 illustrate embodiments for mirrors and reflectors for concentrated solar rays.

In addition to the elements already discussed with reference to previous embodiments such as the transparent non-conductive resin 2 and the glass or polymer 6 with patterned, conductive layer deposited on either surface, there is a highly reflective parabolic or semi cylindrical mirror or concentrator 8 in figure 12 and a thermal solar panel with glass surface 9 in figure 13.

In figures 14 and 15, embodiments for facades, windows and windshields are illustrated where reference 10 identifies a glass sheet and reference 11 identifies double layer glass hermetically isolated by a very high vacuum layer for thermal insulation.

In figure 16, an embodiment for vacuum based photovoltaic solar panel is illustrated. This embodiment comprises a solar panel 12 made out of a chamber with upper glass surface hermetically sealed under very high vacuum for thermal insulation. Solar cells 3 are located on the bottom layer. The interest of this configuration is that Photovoltaic cells (or Polycrystalline Silicon) generates lots of heat especially in hot areas where the outside temperature reaches more than 50°C. The efficiency of the cells is reduced by orders of magnitude. Vacuum being one of the best insulator will keep the Polycrystalline silicon at much lower temperature, therefore higher efficiency.

In figure 17 the electronic means used in the device are illustrated with a microcontroller, a high voltage source, monitoring means and communication means to implement the principle of the invention.

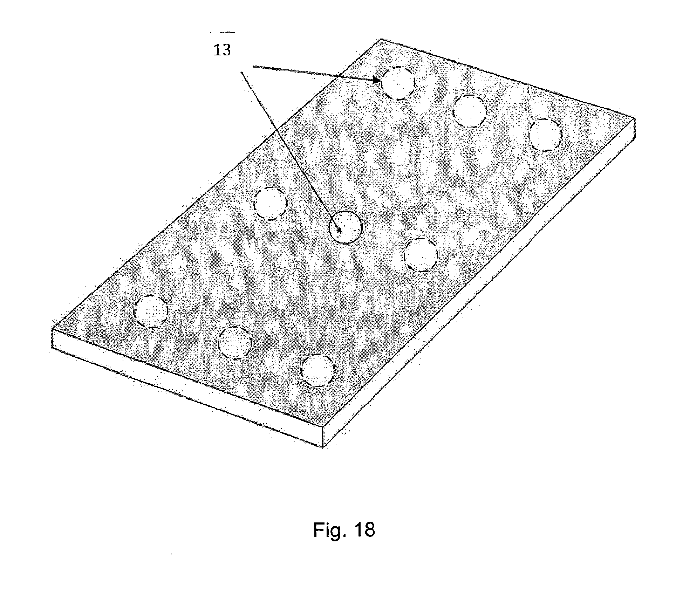

In figure 18, an embodiment of either a solar panel, mirror, reflector, glass surface or the like equipped with either one or multiple piezoelectric devices 13 to create an ultrasonic cleaning waves.

In these configurations, the systems include in addition to the elements already discussed with reference to previous embodiments such as the transparent non-conductive resin 2 and the glass or polymer 6 with patterned, conductive layer deposited on either surface, there is a glass sheet 11 used for windshield, window or façade.

The embodiments and example given in the present application are of course examples that should not be construed in a limiting manner and combinations of different embodiments are possible within the frame of the present invention as defined in the appended claims.

### Reference numbers

1. Glass with patterned, conductive layer deposited on either surface
2. Highly transparent non-conductive resin
3. Photovoltaic or thin film solar cells
4. Back sheet made out of compound material
5. Thin highly transparent sheet made out of Polymers such as Teflon
6. Polymer with patterned, conductive layer deposited on either surface
7. Honeycomb backing made out of metal for heat dissipation or out of other material for high rigidity and light weight backing
8. Highly reflective parabolic or semi cylindrical mirror or concentrator
9. Thermal solar panel with glass surface
10. Glass sheet used for windshield, window or façade
11. Double layer glass hermetically isolated by a very high vacuum layer for thermal insulation
12. A solar panel made out of a chamber with upper glass surface hermetically sealed under very high vacuum for thermal insulation. Solar cells are located on the bottom layer
13.One or multiple Piezoelectric transducers placed on the panel for creating an ultrasonic wave

## Claims

1. A panel, such as a solar panel, comprising at least a self-cleaning device for cleaning the surface of the panel, said cleaning device comprising at least a conductive coating (1, 6) configured for applying pulsed electrostatic DC fields generated by electronic means.

2. The panel of claim 1, wherein it comprises at least a layer of highly transparent non-conductive resin (2).

3. The panel of one of the preceding claim wherein it comprises a back sheet made out of compound material (4).

4. The panel of one of the preceding claims, wherein it comprises a honeycomb backing (7) made out of metal for heat dissipation or out of other material for high rigidity and light weight backing.

5. A panel as defined in claim 1 or 2, wherein it comprises a highly reflective parabolic or semi cylindrical mirror or concentrator (9).

6. A panel as defined in one of claims 1 or 2, wherein it comprises a thermal solar panel with glass surface.

7. A panel as defined in one of claims 1 or 2, wherein it comprises a glass sheet used for windshield, window or façade (11).

8. The panel of one of the preceding claims, wherein it comprises detectors for monitoring and operating the cleaning device.

9. The panel as defined in claim 8, wherein the detectors include luminosity, temperature, humidity and others for automatic operation.

10. The panel as defined in claim 1, wherein it comprises a chamber (12) with upper glass surface hermetically sealed under very high vacuum for thermal insulation and wherein solar cells (3) are located on the bottom layer.

11. A panel as defined in one of the preceding claims, wherein it comprises additional piezoelectric devices (13) to generate additional ultrasonic waves.

12. An installation comprising at least one panel according to one of the preceding claims.

13. A method for cleaning a panel as defined in one of claims 1 to 11 or an installation as defined in claim 12 with a cleaning device using Pulsed electrostatic DC fields.

14. A method for additional cleaning of a panel as defined in one of claims 1 to 11 or an installation as defined in claim 12 with piezoelectric devices that create ultrasonic waves on the surface to remove sand and dust mixed with humidity.

## Patentansprüche

1. Tafel, zum Beispiel eine Solartafel, die mindestens eine selbstreinigende Vorrichtung zum Reinigen der Fläche der Tafel aufweist, wobei die Reinigungsvorrichtung mindestens eine leitende Beschichtung (1, 6) aufweist, die konfiguriert ist, um gepulste elektrostatische Gleichspannungsfelder, die durch elektronische Mittel erzeugt worden sind, anzulegen.

2. Tafel nach Anspruch 1, wobei sie mindestens eine Schicht eines hoch durchlässigen, nichtleitfähigen Harzes (2) aufweist.

3. Tafel nach einem vorhergehenden Anspruch, wobei sie eine Rückplatte, die aus einem Verbundwerkstoff (4) hergestellt ist, aufweist.

4. Tafel nach einem der vorhergehenden Ansprüche, wobei sie eine Wabenträgerstruktur (7) aufweist, die aus einem Metall für eine Wärmeableitung oder aus einem anderen Material für eine hohe Festigkeit und für eine leichtgewichtige Unterlage hergestellt ist.

5. Tafel nach Anspruch 1 oder 2, wobei sie einen hoch reflektierenden, parabolischen oder halbzylindrischen Spiegel oder Konzentrator (9) aufweist.

6. Tafel nach einem der Ansprüche 1 oder 2, wobei sie eine thermische Solartafel mit einer Glasfläche aufweist.

7. Tafel nach einem der Ansprüche 1 oder 2, wobei sie eine Glasplatte aufweist, die für eine Schutzscheibe, für ein Fenster oder für eine Fassade (11) verwendet wird.

8. Tafel nach einem der vorhergehenden Ansprüche, wobei sie Detektoren aufweist, um die Reinigungsvorrichtung zu überwachen und zu betreiben.

9. Tafel nach Anspruch 8, wobei die Detektoren Lichtstärke, Temperatur, Feuchtigkeit und andere für den automatischen Betrieb aufweisen.

10. Tafel nach Anspruch 1, wobei sie eine Kammer (12) mit einer oberen Glasfläche, die unter einem sehr hohen Vakuum für eine thermische Isolierung hermetisch abgedichtet ist, aufweist und wobei Solarzellen (3) auf der Bodenschicht angeordnet sind.

11. Tafel nach einem der vorhergehenden Ansprüche, wobei sie zusätzliche piezoelektrische Vorrichtungen (13) aufweist, um zusätzlich Ultraschallwellen zu erzeugen.

12. Installation, die mindestens eine Tafel nach einem der vorhergehenden Ansprüche aufweist.

13. Verfahren zum Reinigen einer Tafel nach einem der Ansprüche 1 bis 11 oder eine Installation nach Anspruch 12 mit einer Reinigungsvorrichtung, die gepulste elektrostatische Gleichspannungsfelder verwendet.

14. Verfahren zum zusätzlichen Reinigen einer Tafel nach einem der Ansprüche 1 bis 11 oder eine Installation nach Anspruch 12 mit piezoelektrischen Vorrichtungen, die auf der Fläche Ultraschallwellen erzeugen, um Sand und Staub, die mit Feuchtigkeit gemischt sind, zu entfernen.

## Revendications

1. Panneau, tel qu'un panneau solaire, comprenant au moins un dispositif d'autonettoyage pour nettoyer la surface du panneau, ledit dispositif de nettoyage comprenant au moins un revêtement conducteur (1, 6) configuré pour appliquer des champs électrostatiques DC pulsés générés par un moyen électronique.

2. Panneau selon la revendication 1, comprenant au moins une couche de résine non conductrice hautement transparente (2).

3. Panneau selon l'une des revendications précédentes, comprenant une feuille arrière constituée d'un matériau composite (4).

4. Panneau selon l'une des revendications précédentes, comprenant un support en nid d'abeilles (7) constitué d'un métal pour la dissipation de la chaleur ou d'un autre matériau pour un support de grande rigidité et léger.

5. Panneau selon la revendication 1 ou 2, comprenant un miroir ou concentrateur parabolique ou semi-cylindrique hautement réfléchissant (9).

6. Panneau selon la revendication 1 ou 2, comprenant un panneau solaire thermique avec une surface de verre.

7. Panneau selon la revendication 1 ou 2, comprenant une plaque de verre utilisée pour un pare-brise, une fenêtre ou une façade (11).

8. Panneau selon l'une des revendications précédentes, comprenant des détecteurs pour surveiller et faire fonctionner le dispositif de nettoyage.

9. Panneau selon la revendication 8, dans lequel les détecteurs comprennent des détecteurs de luminosité, température, humidité et autres détecteurs pour un fonctionnement automatique.

10. Panneau selon la revendication 1, comprenant une chambre (12) avec une surface supérieure en verre scellée hermétiquement sous vide très poussé pour isolation thermique, et dans lequel des cellules solaires (3) sont situées sur la couche inférieure.

11. Panneau selon l'une des revendications précédentes, comprenant des dispositifs piézoélectriques supplémentaires (13) pour générer des ondes ultrasonores supplémentaires.

12. Installation comprenant au moins un panneau selon l'une des revendications précédentes.

13. Procédé de nettoyage d'un panneau tel que défini dans l'une des revendications 1 à 11 ou d'une installation telle que définie dans la revendication 12 avec un dispositif de nettoyage utilisant des champs électrostatiques DC pulsés.

14. Procédé de nettoyage supplémentaire d'un panneau tel que défini dans l'une des revendications 1 à 11 ou d'une installation telle que définie dans la revendication 12 avec des dispositifs piézoélectriques qui créent des ondes ultrasonores sur la surface pour retirer le sable et la poussière mélangés à l'humidité.
